# EUROPEAN PATENT APPLICATION

(11) **EP 4 697 331 A1**
(43) Date of publication of application: **18.02.2026**
(21) Application number: 25770923.8
(22) Date of filing: 21.05.2025
(51) Int. Cl.: G11C 5/02, G11C 8/00

(54) **MEMORY**

(30) Priority: 11.06.2024 CN 202410753976
(71) Applicant: CXMT Corporation, Hefei, Anhui 230601 (CN)
(72) Inventor: SHANG, Weibing, Hefei, Anhui 230601 (CN); WU, Xianjun, Hefei, Anhui 230601 (CN); QIU, Anping, Hefei, Anhui 230601 (CN); LU, Yaohua, Hefei, Anhui 230601 (CN); LIU, Lu, Hefei, Anhui 230601 (CN); XU, Jing, Hefei, Anhui 230601 (CN); SHAO, Tong, Hefei, Anhui 230601 (CN)
(74) Representative: Gulde & Partner
(86) International application number: PCT/CN2025/096161
(87) International publication number: WO 2025/256364

(57) **Abstract**

Embodiments of this application provide a memory. The memory may include at least a first memory area, a peripheral circuit area, and a second memory area that are arranged in a first direction. The peripheral circuit area is located between the first memory area and the second memory area. The first memory area has a plurality of repeating units in a second direction. Each of the repeating units includes at least two memory banks arranged in the first direction. The first direction is perpendicular to the second direction.

## Description

### CROSS-REFERENCE TO RELATED APPLICATIONS

This application is based on and claims priority of the Chinese Patent Application No. 202410753976.X, filed with the China National Intellectual Property Administration on June 11, 2024 and entitled "MEMORY". The above-referenced disclosure is incorporated herein by reference in its entirety.

### TECHNICAL FIELD

Embodiments of this application relate to the field of semiconductors, and in particular to a memory.

### BACKGROUND

As the pace of intelligence and integration accelerates, technological products impose ever-higher requirements for data storage. In an integrated and interactive system, hardware that originally only needed to store its own data can now store data from both itself and multiple hardware units interacting with it; hardware that originally only stored preset programs now also needs to store training materials to enhance usability of intelligent models; and applications originally targeting individuals now need to handle data queries and data preservation for massive populations. These changes impose requirements for faster interaction speeds and higher capacity on memories within hardware.

### SUMMARY

Embodiments of this application provide a memory, which at least helps increase the capacity of the memory.

According to some embodiments of this application, the embodiments of this application provide a memory. The memory at least includes a first memory area, a peripheral circuit area, and a second memory area that are arranged in a first direction. The peripheral circuit area is located between the first memory area and the second memory area. The first memory area has multiple repeating units in a second direction. Each of the repeating units includes at least two memory banks arranged in the first direction. The first direction is perpendicular to the second direction.

At least two memory banks in the same one of the repeating units share one set of global data lines.

Each of the memory banks includes at least three tiles and one row decoder that are arranged in the second direction.

Each of the memory banks includes an even number of tiles and one row decoder that are arranged in the second direction, and the row decoder has an equal number of tiles arranged on two opposite sides in the second direction.

Each of the memory banks includes a first tile, a second tile, a row decoder, a third tile, and a fourth tile that are sequentially arranged. The capacity of the first tile is equal to that of the fourth tile, and the sum of the capacities of the second tile and the third tile is equal to the capacity of the first tile; or the capacity of the second tile is equal to that of the third tile, and the sum of the capacities of the first tile and the fourth tile is equal to the capacity of the second tile.

The tiles include a functional tile and a normal tile. At least one functional tile and at least two normal tiles are disposed on either side of the row decoder in the second direction. The functional tile is located between two normal tiles. The normal tile includes a normal memory array, and the functional tile includes at least one of a redundant memory array and a check memory array.

A first normal tile, a first functional tile, and a second normal tile are sequentially disposed on a first side of the row decoder in the second direction, and a third normal tile, a second functional tile, and a fourth normal tile are sequentially disposed on a second side of the row decoder in the second direction. The first functional tile includes a check memory array. The first normal tile and the second normal tile share the check memory array in the first functional tile. The second functional tile includes a redundant memory array. The third normal tile and the fourth normal tile share the redundant memory array in the second functional tile.

The capacities of the first normal tile and the third normal tile are equal. The sum of the capacities of the second normal tile and the fourth normal tile is equal to the capacity of the first normal tile. The first normal tile, the second normal tile, and the fourth normal tile share the check memory array in the first functional tile. Check data corresponding to the third normal tile is stored in the check memory array in the second functional tile.

The functional tile shares a subword line driver with the normal tile.

The repeating units include a first repeating unit and a second repeating unit arranged in the first direction. The first repeating unit and the second repeating unit each include at least two memory banks arranged in the second direction and complementary to each other.

A first complementary region in the first repeating unit and a second complementary region in the second repeating unit are arranged in the first direction. The first complementary region and the second complementary region constitute a complementary region. In the repeating units, four memory banks included in the complementary region share one set of global data lines, and every two memory banks in a memory region other than the complementary region share one set of global data lines.

### BRIEF DESCRIPTION OF DRAWINGS

One or more embodiments are exemplified with the figures in the accompanying drawings corresponding to the one or more embodiments. These example descriptions are not intended to limit the embodiments, and unless specifically stated, no scale limitations are constituted by the figures in the accompanying drawings.
FIG. 1 is a schematic layout diagram of a memory; and
FIG. 2 to FIG. 7 are schematic layout diagrams of a memory according to different embodiments of this application.

### DESCRIPTION OF EMBODIMENTS

Embodiments of this application are described in detail below with reference to the accompanying drawings. However, it may be understood by a person of ordinary skill in the art that in the embodiments of this application, many technical details are provided to enable readers to better understand this application. However, the technical solutions claimed in this application may be implemented even without these technical details and various changes and modifications made based on the following embodiments.

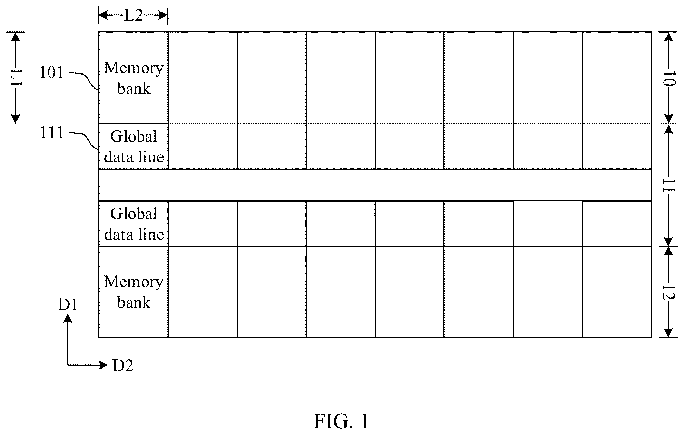

FIG. 1 is a schematic layout diagram of a memory. Referring to FIG. 1, the memory includes a first memory area 10, a peripheral circuit area 11, and a second memory area 12 that are arranged in a first direction D1. The peripheral circuit area 11 is located between the first memory area 10 and the second memory area 12. Multiple memory banks 101 are disposed in the first memory area 10 and the second memory area 12 in a second direction D2. The size L1 of each memory bank 101 in the first direction D1 is equal to the size of the first memory area 10 in the first direction D1. The sizes L2 of different memory banks 101 in the second direction D2 are equal. The sizes of the first memory area 10 and the second memory area 12 in the first direction D1 are equal. Each memory bank 101 has one corresponding set of global data lines 111. Different memory banks 101 correspond to different sets of global data lines 111. The global data lines 111 are disposed in the peripheral circuit area 11.

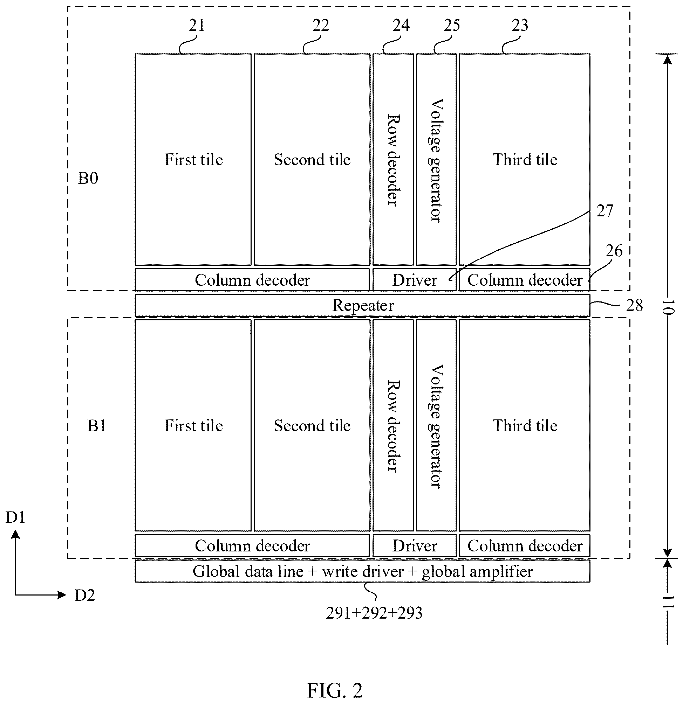

FIG. 2 to FIG. 7 are schematic layout diagrams of a memory according to different embodiments of this application. It may be learned from FIG. 2 as an example that the memory includes a first memory area 10, a peripheral circuit area 11, and a second memory area (not shown) that are arranged in the first direction D1. The peripheral circuit area 11 is located between the first memory area 10 and the second memory area. The first memory area 10 has multiple repeating units M0 in the second direction D2. Each repeating unit M0 includes at least two memory banks arranged in the first direction D1. The first direction D1 is perpendicular to the second direction D2.

In this embodiment of this application, a positional relationship among the first memory area 10, the peripheral circuit area 11, and the second memory area may be similar to that in FIG. 1. A main difference between this embodiment of this application and FIG. 1 lies in different layout manners of the first memory area 10 and the second memory area. Each repeating unit is set to include at least two memory banks arranged in the first direction D1, which helps increase the memory capacity, so as to prepare a large-capacity memory.

The embodiments of this application are described in more detail below with reference to the accompanying drawings.

In some embodiments, at least two memory banks in the same repeating unit share one set of global data lines. Referring to FIG. 2, the repeating unit M0 includes a first memory bank B0 and a second memory bank B1 that are arranged in the first direction D1. The first memory bank B0 and the second memory bank B1 share one set of global data lines 291. The global data lines 291 are disposed on one side that is of the peripheral circuit area 11 and that is close to the first memory area 10. Because different memory banks do not perform data reading and writing at the same moment, sharing one set of global data lines 291 does not cause a data reading and writing conflict and excessively long response duration, which helps reduce the quantity of global data lines and compress the size of the peripheral circuit area 11 in the first direction D1.

It should be noted that when the same repeating unit includes at least four memory banks, every at least two memory banks may share one set of global data lines, that is, the same repeating unit is corresponding to multiple sets of global data lines, or all memory banks in the same repeating unit may share the same set of global data lines, that is, the same repeating unit is corresponding to only one set of global data lines.

In addition, the global data line 291 is connected to a write driver 292 and a global amplifier 293. The write driver 292 is configured to write target data into the global data line 291 based on an external control signal. The global amplifier 293 is connected to the global data line 291 and a global reference data line 291#, and is configured to amplify a voltage difference between the global data line 291 and the global reference data line 291#. In a case that the first memory bank B0 and the second memory bank B1 share the same set of global data lines 291, the first memory bank B0 and the second memory bank B1 may also share the write driver 292 and the global amplifier 293, and both the write driver 292 and the global amplifier 293 are disposed on one side that is of the peripheral circuit area 11 and that is close to the first memory area 10.

In some embodiments, a repeater 28 is further disposed between two memory banks (for example, the first memory bank B0 and the second memory bank B1 in FIG. 2) arranged in the first direction D1. The repeater 28 is connected to the global data line 291, and is configured to enhance the driving capability of the global data line 291, so as to ensure that data in the global data line 291 can be accurately transmitted to one side that is of a memory bank (for example, the first memory bank B0, where the second memory bank B1 is located between the first memory bank B0 and the peripheral circuit area 11 in FIG. 2) away from the peripheral circuit area 11 in the repeating unit M0 and that is away from the peripheral circuit area 11.

In some embodiments, each memory bank includes at least three tiles and one row decoder that are arranged in the second direction D2. Compared with that in the second direction D2, each memory bank includes only one tile or two tiles, each memory bank is split into at least three tiles, which helps reduce the size of a single memory bank or a single tile in the first direction D1 in a case that the capacity of the memory bank remains unchanged. In this way, the reasonable size of the first memory area 10 in the first direction D1 is ensured, and packaging is facilitated, which helps ensure that data in the global data line 291 can be accurately transmitted from one end of each tile near the peripheral circuit area 11 to another end away from the peripheral circuit area 11, reduces a possibility of an error due to a long data transmission distance, facilitates setting only a single-ended column decoder 26 for each memory bank instead of setting a double-ended column decoder, and further reduces the size of the first memory area in the first direction.

In an actual application process, each memory bank has a corresponding column decoder 26. Therefore, a region and the quantity of the memory banks may be defined and divided by using a correspondence of the column decoder 26. The column decoder 26 is generally disposed on one side that is of the memory bank and that faces the peripheral circuit area, or on two opposite sides of the memory bank in the first direction. To avoid an excessively long maximum transmission distance of an output signal of the column decoder 26, when the size of the memory bank in the first direction is too large, the column decoder may be disposed on two opposite sides of the memory bank. When the size of the memory bank in the first direction does not affect signal transmission quality, the column decoder may be disposed only on one side that is of the memory bank and that faces the peripheral circuit area. When each memory bank includes multiple tiles arranged in the second direction, the column decoder is disposed on one side that is of each tile and that face the peripheral circuit area.

Correspondingly, the row decoder may be located between two tiles, that is, the row decoder is not located at an edge position of the memory bank. In this way, a maximum distance between the row decoder and each of different tiles is shortened, thereby ensuring that an output signal of the row decoder can be effectively transmitted to different tiles, and avoiding an error in a signal transmission process due to an excessively long signal transmission distance.

In some embodiments, each memory bank includes an odd number of tiles and one row decoder that are arranged in the second direction D2, and the row decoder has unequal numbers of tiles arranged on two opposite sides in the second direction. Referring to FIG. 2, the first memory bank B0 is used as an example. The memory bank includes a first tile 21, a second tile 22, a third tile 23, and a row decoder 24. The row decoder 24 is located between the second tile 22 and the third tile 23, and the quantities of tiles on two opposite sides of the row decoder 24 are different. It should be noted that, in a case that the quantities of the tiles on two opposite sides of the row decoder 24 are different, the capacities of the tiles on two opposite sides of the row decoder 24 still may be equal. This is because the capacities of the tiles may be different. In the embodiments of this application, the capacity of a tile is only related to the size (or the area) of the tile, and the memory densities of different tiles are considered to be the same.

In one embodiment, the capacities of the first tile 21, the second tile 22, and the third tile 23 are equal. The capacities being equal means that the sizes of different tiles in the first direction D1 are equal, and the sizes of different tiles in the second direction D2 are equal. In the embodiment shown in FIG. 2, the sizes of the three tiles in the second direction D2 are all 8.75 MATs (MAT, Memory Array Tile, Memory Array Tile).

In some embodiments, each MAT corresponds to 64 or 128 column addresses in the second direction D2, and each column address corresponds to four bit lines and four local data lines in the MAT. A local data line and a bit line are connected by using a column selection transistor, and four column selection transistors corresponding to the same column address receive the same column selection signal. Data of the local data line is subsequently transmitted to the global data line 291. When the size of each tile in the second direction D2 is 8.75 MATs, the following size allocation may be performed. The width of eight MATs is used to store normal data. The size of 0.5 MATs is used to store check data, such as an error correction code (ECC, error correct code). The check data is a check code of the normal data. The check data is a check code for the normal data, is generated based on the normal data, and is used to correct the normal data when an error occurs in the normal data. A width of 0.25 MATs is a redundant bit line, and is used to replace a damaged bit line.

In some embodiments, FIG. 2 is used as an example. A voltage generator 25 is further disposed on each memory bank in the second direction D2. The voltage generator 25 is configured to generate a supply voltage required by a bit line amplifier. The bit line amplifier is configured to amplify a voltage difference between a bit line and a reference bit line. The voltage generator 25 may be independently disposed relative to the row decoder 24, or may be mixed with the row decoder 24 in the same circuit region. When the voltage generator 25 and the row decoder 24 are independently disposed, the row decoder 24 and the voltage generator 25 may be disposed adjacent to each other or may be spaced apart, for example, a part of memory array tiles are located between the row decoder 24 and the voltage generator 25. When the voltage generator 25 and the row decoder 24 are mixed in the same circuit region, the voltage generator 25 is disposed in a mixed manner with the row decoder 24 in a region with a relatively small channel pressure in the circuit region, and only the row decoder 24 is disposed in another circuit region, so that the row decoder 24 is better arranged for outputting a channel of a main word line control signal. By defining that the voltage generator 25 is disposed in parallel with the tile in the second direction, the size of the memory bank in the first direction is reduced, so that multiple memory banks are disposed in the first direction in the first memory area.

In some embodiments, a driver 27 is disposed on the row decoder 24, or one side that is of the row decoder 24 and the voltage generator 25 and that faces the peripheral circuit area 11, and the driver 27 is configured to improve the driving capability of a signal, so as to ensure accurate signal transmission.

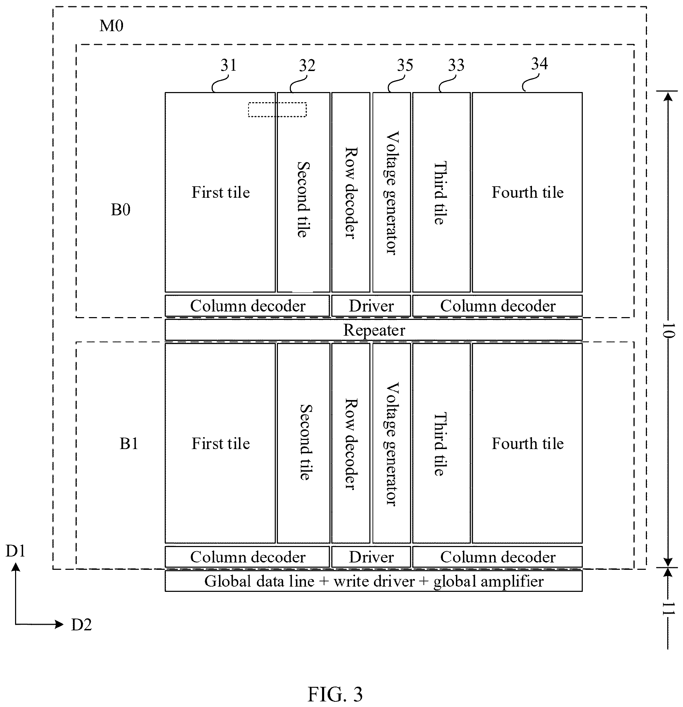

In some embodiments, each memory bank includes an even number of tiles and one row decoder that are arranged in the second direction, and the row decoder has an equal number of tiles arranged on opposite sides in the second direction. Referring to FIG. 3, the first memory bank B0 is used as an example. The first memory bank B0 includes a first tile 31, a second tile 32, a row decoder 35, a third tile 33, and a fourth tile 34 that are sequentially arranged. Two tiles are disposed on two opposite sides of the row decoder 35.

In some embodiments, further referring to FIG. 3, the capacity of the first tile 31 is equal to that of the fourth tile 34, and the sum of the capacities of the second tile 32 and the third tile 33 is equal to the capacity of the first tile 31. In another embodiment, the capacity of the second tile is equal to that of the third tile, and the sum of the capacities of the first tile and the fourth tile is equal to the capacity of the second tile. That is, in this application, a large tile is split into two small tiles (the second tile 32 and the third tile 33) in the embodiment shown in FIG. 3, and the row decoder 35 is disposed in the second tile 32 and the third tile 33. In this way, the row decoder 35 is located in an intermediate region of the first memory bank B0 in the second direction D2, thereby shortening a maximum signal transmission distance between the row decoder 35 and any tile, and reducing a signal transmission difference.

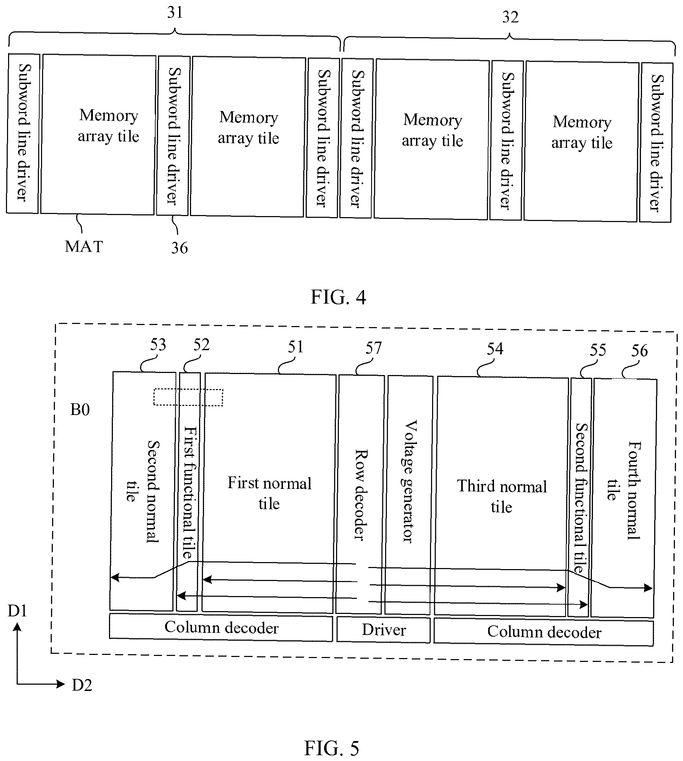

In some embodiments, referring to FIG. 4, FIG. 4 is an enlarged view of a dashed region of the memory shown in FIG. 3. It may be learned from FIG. 4 that a subword line driving structure 36 is not shared between the first tile 31 and the second tile 32. Similarly, a subword line driving structure is neither shared between the third tile and the fourth tile. In this way, the subword line driving structures 36 in the first tile 31 and the second tile 32 may be separately controlled by using different control signals, so as to avoid that different tiles need to be uniformly controlled, thereby causing an excessively long maximum transmission distance of the control signal. In a case that different control signals are used, different control signals may be transmitted by using different metal layers. In another embodiment, the subword line driving structure 36 may alternatively be shared between the first tile 31 and the second tile 32.

Further, the subword line driving structure 36 is not shared between the first tile 31 and the second tile 32. A metal layer that has a first unit resistance may be mainly used for signal transmission between the row decoder 35 and the second tile 32. A metal layer that has a second unit resistance may be mainly used for signal transmission between the row decoder 35 and the first tile 31. The second unit resistance is less than the first unit resistance. In this way, signal transmission resistances between the row decoder 35 and different tiles are similar, and a difference of signal transmission between the row decoder 35 and different tiles is further reduced, so that the memory has more stable performance.

In some embodiments, each tile includes a normal memory array for storing normal data, a check memory array for storing check data, and a redundant memory array for repair, for example, in the embodiments shown in FIG. 2 and FIG. 3. In still some other embodiments, the normal memory array may be disposed separately from the check memory array and the redundant memory array.

In some embodiments, the tiles in the memory bank include a functional tile and a normal tile. At least one functional tile and at least two normal tiles are disposed on either side of the row decoder in the second direction. The functional tile is located between two normal tiles. The normal tile includes a normal memory array, and the functional tile includes at least one of a redundant memory array and a check memory array. The tiles are divided into a functional tile and a normal tile, which helps make the widths/width of the normal tile and/or the functional tile in the second direction be an integer number of MATs, thereby reducing difficulty in process manufacturing. In addition, the functional tile is disposed between two normal tiles, so that different normal tiles share a functional tile, thereby improving degree of integration and utilization of the functional tile.

In some embodiments, referring to FIG. 5, the functional tile includes a first functional tile 52 and a second functional tile 55, and the normal tile includes a first normal tile 51, a second normal tile 53, a third normal tile 54, and a fourth normal tile 56. The first normal tile 51, the first functional tile 52, and the second normal tile 53 are sequentially disposed on a first side of the row decoder 57 in the second direction D2, and the third normal tile 54, the second functional tile 55, and the fourth normal tile 56 are sequentially disposed on a second side of the row decoder 57 in the second direction D2. The first functional tile 52 includes a check memory array. The first normal tile 51 and the second normal tile 53 share the check memory array in the first functional tile 52. The second functional tile 55 includes a redundant memory array. The third normal tile 54 and the fourth normal tile 55 share the redundant memory array in the second functional tile 55.

In some embodiments, the capacities of the first normal tile 51 and the third normal tile 54 are equal. The sum of the capacities of the second normal tile 53 and the fourth normal tile 56 is equal to the capacity of the first normal tile 51. The first normal tile 51, the second normal tile 52, and the fourth normal tile 56 share the check memory array in the first functional tile 52. The check data corresponding to the normal data in the third normal tile 54 is stored in the check memory array in the second functional tile 55. In this embodiment, only the check memory array is disposed in the first functional tile 52, and is configured to store the check data. The normal data corresponding to the check data is stored in the first normal tile 51, the second normal tile 52, and the fourth normal tile 56. Correspondingly, both the check memory array and the redundant memory array are disposed in the second functional tile 55. The redundant memory array is shared by all normal tiles, and the check memory array in the second functional tile 55 is corresponding to only the third normal tile 54, and is configured to store the check data corresponding to the normal data stored in the third normal tile 54.

For the sizes of different tiles in the second direction D2 in FIG. 5, the sizes of the first normal tile 51 and the third normal tile 54 in the second direction D2 may be 8 MATs, and the sizes of the second normal tile 53 and the fourth normal tile 56 in the second direction D2 may be 4 MATs. That is, the sizes of the second normal tile 53 and the fourth normal tile 56 in the second direction D2 are equal. The sizes of the first functional tile 52 and the second functional tile 55 in the second direction D2 are both 1 MAT, the first functional tile 52 has only a check memory array, and the second functional tile 55 includes a check memory array of 0.5 MATs and a redundant memory array of 0.5 MATs. Different tiles are controlled to share the same redundant memory array, which helps improve utilization of the redundant memory array, and helps reduce the size of the memory bank in the second direction.

In another embodiment, the check memory array and the redundant memory array are disposed in both the first functional tile and the second functional tile, the first normal tile and the second normal tile share the check memory array and the redundant memory array in the first functional tile, and the third normal tile and the fourth normal tile share the check memory array and the redundant memory array in the second functional tile. For example, the sizes of the first functional tile and the second functional tile in the second direction are both 1 MAT, and the first functional tile and the second functional tile each includes a check memory array of 0.75 MATs and a redundant memory array of 0.25 MATs. In this way, the check memory array and the redundant memory array are relatively close to corresponding normal memory arrays, thereby facilitating signal transmission, and making memory array layouts on two sides of the row decoder as symmetrical as possible.

In some embodiments, the functional tile and the normal tile share a subword line driver. In this way, the size of the memory bank in the second direction is reduced, and then the size of the memory in the second direction is further reduced, or the capacity of the memory is increased when the size of the memory does not change. When the subword line driver is shared, if a word line in a normal tile is opened, a corresponding word line in the functional tile is also opened. In addition, the same functional tile may share different subword line drivers with different normal tiles. In this case, the functional tile may be disposed between different normal tiles, thereby avoiding mutual interference between different normal tiles.

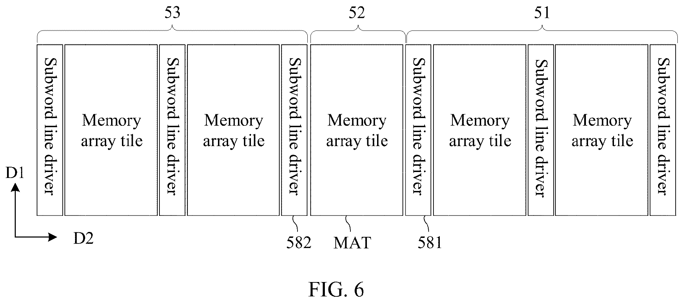

Referring to FIG. 6, the first normal tile 51 and the first functional tile 52 share a first subword line driver 581, and the first functional tile 52 and the second normal tile 53 share a second subword line driver 582. Each subword line driver may simultaneously control word lines in the memory array tiles on two sides. One of two adjacent subword line drivers is used to control an odd word line, and the other is used to control an even word line. An activation operation of the first normal tile 51 does not affect the second normal tile 53. In addition, the word lines in the first normal tile 51 and the second normal tile 53 may be activated at intervals, so that only one word line in the first functional tile 52 is activated at the same moment, thereby effectively writing check data.

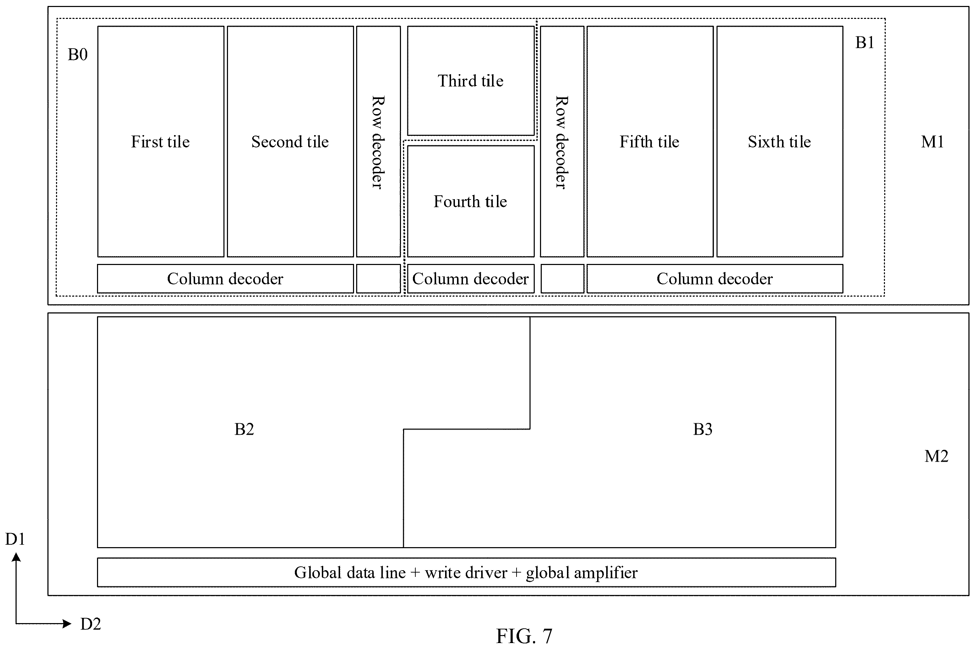

In some embodiments, the repeating units include a first repeating unit and a second repeating unit arranged in the first direction. The first repeating unit and the second repeating unit each include at least two memory banks arranged in the second direction and complementary to each other. Referring to FIG. 7, the first repeating unit M1 includes a first memory bank B0 and a second memory bank B1 that are complementary, and the second repeating unit M2 includes a third memory bank B2 and a fourth memory bank B3 that are complementary. In the first repeating unit M1, the third tile included in the first memory bank B0 and the fourth tile included in the second tile B1 are complementary. A layout of the first repeating unit M1 may be the same as that of the second repeating unit M2.

It may be understood that complementarity refers to positions of different memory banks in the second direction are overlapped. When the first repeating unit is formed by three memory banks arranged in the second direction and complementary to each other, it actually refers to that the memory bank at an intermediate position has two protruding parts, and each protruding part is complementary to the protruding part of the another memory bank, so that the sizes of different positions of the repeating unit in the first direction are the same.

In some embodiments, a first complementary region in the first repeating unit and a second complementary region in the second repeating unit are arranged in the first direction. The first complementary region and the second complementary region constitute a complementary region. In the repeating units, four memory banks included in the complementary region share one set of global data lines, and every two memory banks in a memory region other than the complementary region share one set of global data lines. It may be learned from FIG. 7 that if the first complementary region of the first repeating unit M1 and the second complementary region of the second repeating unit M2 are arranged in the first direction, the layout of the first repeating unit M1 is substantially the same as that of the second repeating unit M2, and the complementary region that includes the first complementary region and the second complementary region is actually corresponding to the first memory bank B0, the second memory bank B1, the third memory bank B2, and the fourth memory bank B3. The four memory banks share the same set of global data lines in a part of the complementary region, but are located outside the complementary region, are located at any position of the repeating unit in the second direction, and are all corresponding to only two memory banks, for example, the first memory bank B0 and the third memory bank B2, or the second memory bank B1 and the fourth memory bank B3.

In some embodiments, the capacities of the multiple memory banks constituting the first repeating unit may be equal or different. The numbers of the tiles included in the different memory banks may be equal or different. The sizes of the different tiles in the first direction may be equal or different. Referring to FIG. 7, the first memory bank B0 includes a first tile, a second tile, and a third tile. The second memory bank B1 includes a fourth tile, a fifth tile, and a sixth tile. The first tile and the second tile are located on a first side of a corresponding row decoder. The third tile is located on a second side of the corresponding row decoder. The fifth tile and the sixth region are located on the second side of the corresponding row decoder. The third tile is located on the first side of the corresponding row decoder. The sizes of the third tile and the fourth tile in the second direction and the first direction are all equal. The sum of the sizes of the third tile and the fourth tile is equal to the size of the first tile. The sizes of the first tile, the second tile, the fifth tile, and the sixth tile are all equal.

It should be noted that the tile shown in FIG. 7 may be a normal tile, and may also include a normal memory array, a redundant memory array, and a check memory array at the same time. In addition, because tiles (three tiles) at an upper half part of the first memory bank B0 are more than tiles (two tiles) at a lower half part of the first memory bank B0, the row decoder needs to transmit a main word line control signal on the upper half part by using more channels. Therefore, the voltage generator of the first memory bank B0 may be disposed in a mixed manner with the lower half part of the row decoder, so as to reduce a channel pressure of the upper half part. Similarly, the voltage generator of the second memory bank B1 may be disposed in a mixed manner with the upper half part of the row decoder, so as to reduce a channel pressure of the lower half part.

A person of ordinary skill in the art may understand that the foregoing implementations are specific embodiments for implementing this application. In actual application, various modifications may be made to the forms and details of the implementations without departing from the spirit and scope of this application. Any person skilled in the art may make changes and modifications without departing from the spirit and scope of this application. Therefore, the protection scope of this application shall be subject to the scope defined by the claims.

## Claims

1. A memory, comprising:
a first memory area (10), a peripheral circuit area (11), and a second memory area (12) that are arranged in a first direction (D1), wherein the peripheral circuit area (11) is located between the first memory area (10) and the second memory area (12), the first memory area (10) has a plurality of repeating units (M0) in a second direction (D2), and each of the repeating units comprises at least two memory banks (101) arranged in the first direction (D1); and the first direction (D1) is perpendicular to the second direction (D2).

2. The memory according to claim 1, wherein at least two memory banks (101) in a same one of the repeating units share one set of global data lines (291).

3. The memory according to claim 1, wherein each of the memory banks (101) comprises at least three tiles and one row decoder (24, 35, 57) that are arranged in the second direction (D2).

4. The memory according to claim 3, wherein each of the memory banks (101) comprises an even number of tiles and one row decoder that are arranged in the second direction (D2), and the row decoder has an equal number of tiles arranged on two opposite sides in the second direction (D2).

5. The memory according to claim 4, wherein each of the memory banks (101) comprises a first tile, a second tile, a row decoder, a third tile, and a fourth tile that are sequentially arranged; and a capacity of the first tile is equal to that of the fourth tile, and a sum of capacities of the second tile and the third tile is equal to the capacity of the first tile; or a capacity of the second tile is equal to that of the third tile, and a sum of capacities of the first tile and the fourth tile is equal to the capacity of the second tile.

6. The memory according to claim 3, wherein the tiles comprise a functional tile and a normal tile, at least one functional tile and at least two normal tiles are disposed on either side of the row decoder in the second direction (D2), and the functional tile is located between two normal tiles; and the normal tile comprises a normal memory array, and the functional tile comprises at least one of a redundant memory array and a check memory array.

7. The memory according to claim 6, wherein a first normal tile (51), a first functional tile (52), and a second normal tile (53) are sequentially disposed on a first side of the row decoder in the second direction (D2), a third normal tile (54), a second functional tile (55), and a fourth normal tile (56) are sequentially disposed on a second side of the row decoder in the second direction (D2), the first functional tile (52) comprises a check memory array, the first normal tile (51) and the second normal tile (53) share the check memory array in the first functional tile (52), the second functional tile (55) comprises a redundant memory array, and the third normal tile (54) and the fourth normal tile (56) share the redundant memory array in the second functional tile (55).

8. The memory according to claim 7, wherein capacities of the first normal tile (51) and the third normal tile (54) are equal, a sum of capacities of the second normal tile (53) and the fourth normal tile (56) is equal to the capacity of the first normal tile (51), the first normal tile (51), the second normal tile (53), and the fourth normal tile (56) share the check memory array in the first functional tile (52), and check data corresponding to the third normal tile (54) is stored in a check memory array in the second functional tile (55).

9. The memory according to claim 6, wherein the functional tile shares a subword line driver with the normal tile.

10. The memory according to claim 2, wherein the repeating units comprise a first repeating unit and a second repeating unit arranged in the first direction (D1), and the first repeating unit and the second repeating unit each comprise at least two memory banks (101) arranged in the second direction (D2) and complementary to each other.

11. The memory according to claim 10, wherein a first complementary region in the first repeating unit and a second complementary region in the second repeating unit are arranged in the first direction (D1), the first complementary region and the second complementary region constitute a complementary region, and in the repeating units, four memory banks (101) in the complementary region share one set of global data lines, and every two memory banks (101) in a memory region other than the complementary region share one set of global data lines.
